# EUROPEAN PATENT APPLICATION

(11) **EP 3 179 836 A1**
(43) Date of publication of application: **14.06.2017**
(21) Application number: 15869343.2
(22) Date of filing: 18.12.2015
(51) Int. Cl.: H05K 5/04, H04M 1/02, H01Q 1/24

(54) **ELECTRONIC COMMUNICATION DEVICE WITH METAL CASING AND MANUFACTURING METHOD THEREFOR**

(30) Priority: 18.12.2014 CN 201410800392; 02.06.2015 CN 201510296630
(71) Applicant: Xiaomi Inc., Beijing 100085 (CN)
(72) Inventor: WANG, Jianyu, Beijing 100085 (CN); LI, Zhuxin, Beijing 100085 (CN); WANG, Guohua, Beijing 100085 (CN)
(74) Representative: Robson, Aidan John
(86) International application number: PCT/CN2015/097799
(87) International publication number: WO 2016/095836

(57) **Abstract**

The present disclosure relates to an electronic communication device having a metal housing and a manufacturing method thereof, to provide an electronic communication device having an integrated appearance. In the electronic communication device, a partition strip is formed on the metal housing and by at least two broken marks formed by a plurality of micro vias passing through the metal housing. In the electronic communication device provided by the above technical solution, the metal housing is partitioned into several parts through at least two broken marks formed by the plurality of micro vias. Since electrical conduction is suppressed between the partitioned parts of the metal housing, it is facilitate to realize the related performance of the electronic communication device, such as a signal radiation of an antenna. Furthermore, the micro vias are very small, the broken marks formed by the micro vias are also very small, naked eyes of a person generally cannot see these micro vias and broken marks at all, thereby, slots or trace lines cannot be seen from the overall appearance of the electronic communication device, and the overall appearance is integral and beautiful.

## Description

### CROSS-REFERENCE TO RELATED APPLICATIONS

This application is based upon and claims priority to Chinese Patent Application No. 201410800392.X, filed December 18, 2014 and Chinese Patent Application No. 201510296630.2, filed June 2, 2015, the entire contents of which are incorporated herein by reference.

### TECHNICAL FIELD

The present disclosure relates to the technical field of electronic communication devices, and more particularly, to an electronic communication device having a metal housing and a manufacturing method thereof.

### BACKGROUND

At present, in an electronic communication device having a metal housing, such as a mobile phone, in order to ensure the performance of a built-in antenna, an overall metal housing will be partitioned into several parts, and then the partitioned metal parts may be connected with plastics through in-mold decoration, so as to avoid that the partitioned metal parts are conducted to influence signals of the antenna. This results that the metal housing will be partitioned by several pieces of plastic partition strips on the metal housing, and the overall electronic communication device cannot reach an integrated effect, thus affecting the overall appearance.

### SUMMARY

In order to overcome problems existed in related arts, the embodiments of the present disclosure provide an electronic communication device having a metal housing and a manufacturing method thereof, so as to provide an electronic communication device having an integrated appearance.

According to a first aspect of embodiments of the present disclosure, there is provided an electronic communication device having a metal housing, including: a partition strip, formed on the metal housing, wherein the partition strip is formed by at least two broken marks formed by a plurality of micro vias passing through the metal housing.

In one embodiment, the plurality of micro vias include a plurality of micro vias formed by laser on an outside surface of the metal housing.

In one embodiment, the electronic communication device further includes: a support member, provided on an inside surface of the metal housing on which the partition strip is formed.

In one embodiment, a size of the support member is larger than a size of the partition strip.

In one embodiment, the plurality of micro vias are filled with insulation filler.

In one embodiment, the support member includes an insulation support member; and
the insulation support member and the insulation filler are integrally formed.

In one embodiment, a shape of the partition strip is a shape of the broken mark formed by micro vias at an outer edge among the plurality of micro vias; and
a broken mark formed by micro vias enclosed within the micro vias at the outer edge and the broken mark formed by the micro vias at the outer edge are parallel to each other.

In one embodiment, a cavity surrounded by the metal housing is provided with an antenna; and
a position of the partition strip on the metal housing corresponds to a signal radiation position of the antenna.

In one embodiment, the metal housing comprises one or both of a metal frame and a metal back housing; and
the partition strip is formed on one or both of the metal frame and the metal back housing.

In one embodiment, a number of the partition strips formed on the metal frame is at least two; and
a part of the metal frame between two adjacent partition strips among the at least two partition strips is used to form a part of the antenna in the electronic communication device.

In one embodiment, a number of the partition strips formed on the metal back housing is at least two; and
a part of the metal back housing between two adjacent partition strips among the at least two partition strips is used to form a part of the antenna in the electronic communication device.

In one embodiment, a shape of a region partitioned, on the metal back housing, by the partition strip formed on the metal back housing couples and matches with the antenna.

According to a second aspect of embodiments of the present disclosure, there is provided a method for manufacturing an electronic communication device having a metal housing, including:
providing a plurality of micro vias passing through the metal housing, and forming a partition strip of the metal housing by at least two broken marks formed by the plurality of micro vias.

In one embodiment, the providing a plurality of micro vias passing through the metal housing includes:
forming a plurality of micro vias by laser on an outside surface of the metal housing.

In one embodiment, the method further includes:
providing a support member on an inside surface of the metal housing on which the partition strip is formed.

In one embodiment, a size of the support member is larger than a size of the partition strip.

In one embodiment, the method further includes:
filling insulation filler in the plurality of micro vias.

In one embodiment, the support member includes an insulation support member;
the providing a support member on an inside surface of the metal housing on which the partition strip is formed and the filling insulation filler in the plurality of micro vias include:
squeezing from the inside surface to the outside surface of the metal housing on which the partition strip is formed by using insulation material, so that the insulation material enters into the plurality of micro vias to form the insulation filler and the insulation material forms the insulation support member on the inside surface of the metal housing on which the partition strip is formed, and the insulation support member and the insulation filler are integrally formed.

The technical solutions provided by the embodiments of the present disclosure may include the following advantageous effects:
In the electronic communication device provided by the above technical solution, the metal housing is partitioned into several parts through at least two broken marks formed by the plurality of micro vias passing through the metal housing. Since electrical conduction is suppressed between the partitioned parts of the metal housing, it is facilitate to realize the related performance of the electronic communication device, such as a signal radiation of an antenna. Furthermore, the micro vias are very small, the broken marks formed by the micro vias are also very small, naked eyes of a person generally cannot see these micro vias and broken marks at all, thereby, slots or trace lines cannot be seen from the overall appearance of the electronic communication device, and the overall appearance is integral and beautiful.

It is to be understood that both the foregoing general description and the following detailed description are exemplary and explanatory only and are not restrictive of the invention, as claimed.

### BRIEF DESCRIPTION OF THE DRAWINGS

The accompanying drawings, which are incorporated in and constitute a part of this specification, illustrate embodiments consistent with the invention, and together with the description, serve to explain the principles of the invention.
Fig. 1 is a structurally schematic diagram illustrating a metal housing of an electronic communication device, according to an exemplary embodiment.
Fig. 2A is a three-dimensional enlarged view of a partition strip in a dotted box 10 of Fig. 1.
Fig. 2B is a front enlarged view of a partition strip in a dotted box 10 of Fig. 1.
Fig. 3 is a schematic diagram illustrating a local structure of an electronic communication device, according to an exemplary embodiment.
Fig. 4 is a schematic diagram illustrating a shape of a partition strip on the metal housing of an electronic communication device, according to an exemplary embodiment.
Fig. 5 is a schematic diagram illustrating a shape of another partition strip on the metal housing, according to an exemplary embodiment.
Fig. 6 is a three-dimensional diagram of a metal housing of another electronic communication device, according to an exemplary embodiment.
Fig. 7 is a top enlarged view of a local structure of an electronic communication device in Fig. 6.
Fig. 8 is a block diagram applicable for an electronic communication device having a metal housing, according to an exemplary embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

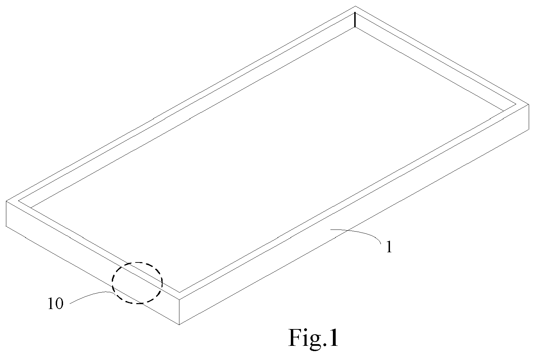

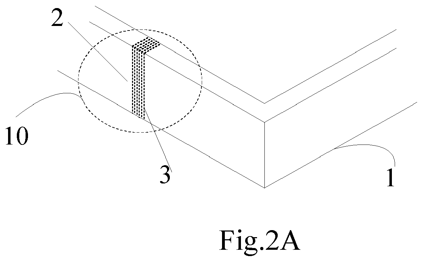

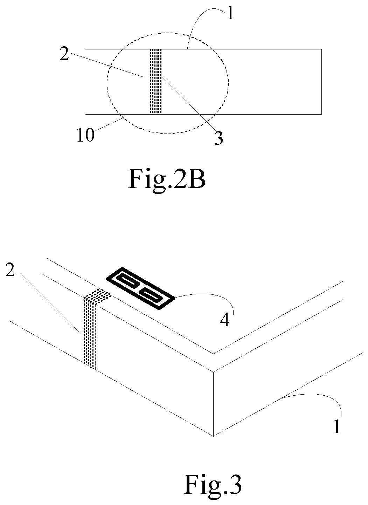

The embodiments of the present disclosure provide an electronic communication device having a metal housing, the electronic communication device may be any electronic device having a communication function, such as a mobile phone, a tablet, a laptop computer, a router, and a camera device, and the interior of the electronic communication device is usually provided with an antenna, such as a GPS (Global Positioning System) antenna, and a WIFI antenna, so as to realize the communication function. As shown in Fig. 1, Fig. 2A and Fig. 2B:

A partition strip 2 is formed on a metal housing 1 of the electronic communication device, the partition strip 2 is formed by at least two broken marks formed by a plurality of micro vias 3 passing through the metal housing 1.

Fig. 1 takes the partition strip provided on a metal frame of the metal housing as an example. Since naked eyes of a person cannot see the micro vias, the broken marks formed by the micro vias, and the partition strip formed by the broken marks, there is no trace about the partition strip in a three-dimensional diagram of the metal housing 1 shown in Fig. 1. Fig. 2A is a three-dimensional enlarged view of a partition strip in a dotted box 10 of Fig. 1, and Fig. 2B is a front enlarged view of a partition strip in a dotted box 10 of Fig. 1.

The micro vias 3 may be of any shape, such as a circle, an oblong, and a rectangle. A size of the micro vias 3 may be adopted on the basis of being not easily to be observed by the naked eye of the person, for example, the size of the micro vias 3 may be less than 0.1mm.

In the above electronic communication device provided by the embodiments of the present disclosure, the metal housing is partitioned into several parts through at least two broken marks formed by the plurality of micro vias passing through the metal housing. Since electrical conduction is suppressed between the partitioned parts of the metal housing, it is facilitate to realize the related performance of the electronic communication device, such as a signal radiation of an antenna. Furthermore, the micro vias are very small, the broken marks formed by the micro vias are also very small, and naked eyes of a person generally cannot see these micro vias and broken marks at all, thereby, slots or trace lines cannot be seen from the overall appearance of the electronic communication device, and the overall appearance is integral and beautiful.

In one embodiment, the plurality of micro vias may be a plurality of micro vias formed by laser on an outside surface of the metal housing.

In one embodiment, the partition strip may be provided at a position of the metal housing that needs to be partitioned. For example, in order to improve the signal radiation performance of the antenna, as shown in Fig. 3, a cavity surrounded by the metal housing 1 is provided with an antenna 4; a position of the partition strip 2 on the metal housing 1 corresponds to a signal radiation position of the antenna 4. In general, in an electronic communication device having a metal housing, such as a mobile phone, and a tablet, the metal housing thereof may include any one or both of a metal frame and a metal back housing; and the antenna is usually close to the metal frame, or the antenna is provided on the inside surface of the metal back housing. Thereby, in order to facilitate the performance of the antenna, the partition strip may be formed on the metal frame or the metal back housing, or may be formed on both the metal frame and the metal back housing at the same time, or the set position may be selected as actually needed. Thus, the metal housing 1 will be partitioned into several parts by at least two partition strips formed by the plurality of micro vias, electrical conduction is suppressed between the partitioned parts of the metal housing, so as to enhance the signal radiation of the antenna, and ensure the performance of the antenna. In addition, a size of the partition strip is related to the coupling degree of antenna signals, such that the size of the partition strip may be adjusted according to the signal intensity of the antenna.

In one embodiment, if the number of the partition strips formed on the metal frame is at least two, a part of the metal frame between two adjacent partition strips among the at least two partition strips may be used to form a part of the antenna in the electronic communication device. If the number of the partition strips formed on the metal back housing is at least two, a part of the metal back housing between two adjacent partition strips among the at least two partition strips is used to form a part of the antenna in the electronic communication device. At this time, a shape of a region partitioned, on the metal back housing, by the partition strip formed on the metal back housing may couple and match with the antenna, for example, it may be of a ring shape, a T shape, and the like.

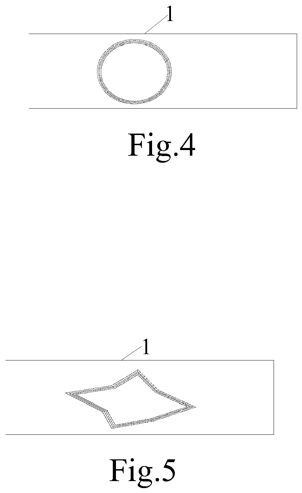

In one embodiment, as shown in Fig. 2A, a shape of the partition strip 2 is a shape of the broken mark formed by micro vias at the outer edge among the plurality of micro vias 3. The partition strip 2 may be designed to be of any shape as needed, such as an oblong (as shown in Fig. 2A or Fig. 2B), a circular ring (as shown in Fig. 4), or an irregular shape (as shown in Fig. 5, but not limited to the shape shown in Fig. 5).

In addition, a broken mark 32 formed by micro vias enclosed within the micro vias 30 at the outer edge and the broken mark 31 formed by the micro vias 30 at the outer edge may be parallel to each other, which is convenient for manufacture. For example, as shown in Fig. 2A and Fig. 2B, pieces of linear broken marks are parallel to each other; as shown in Fig. 4, pieces of annular broken marks are parallel to each other; and as shown in Fig. 5, pieces of irregular shaped broken marks are parallel to each other. Of course, the broken marks may also be provided by non-parallel broken marks as needed. distances between respective broken marks are not limited, and the distances may be adjusted as actually needed, for example, the distances between respective broken marks may be evenly, which is convenient for manufacture, or may be unevenly.

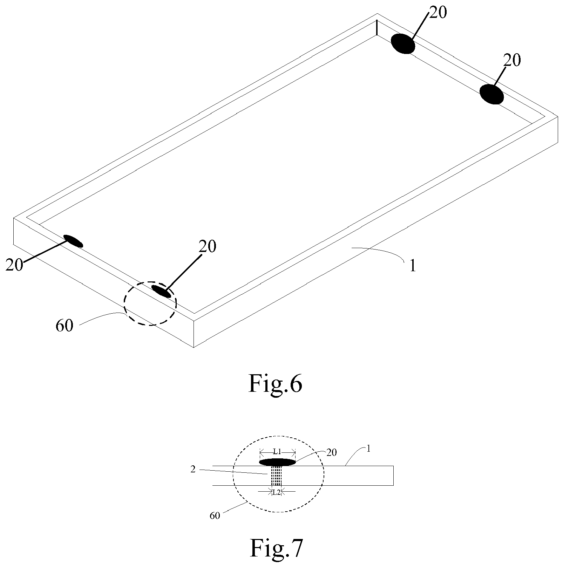

In one embodiment, in order to increase the stability of the partition strip, and increase the strength of the metal housing, as shown in Fig. 6 and Fig. 7, a support member 20 may be provided on the inside surface of the metal housing on which the partition strip 2 is formed. Fig. 6 and Fig. 7 take two partition strips provided on two opposite metal frames of the metal housing, and a support member provided for each partition strip as an example. Fig. 6 is a three-dimensional diagram of a metal housing of an electronic communication device, the naked eyes of the person cannot see the partition strip, thereby, the partition strip is not shown in Fig. 6. Fig. 7 is a top enlarged view of a dotted box 60 in Fig.6. The support member is used to support the part of the metal housing partitioned by the partition strip, so as to increase the strength of the metal housing. In order not to influence the performance of the antenna, the support member may also be provided as an insulation support member made of insulation material. If the conductivity of the inside surface of the metal housing on which the partition strip is formed may not be considered, a support member made of any other material may also be used, which material is used to make the support member may be determined as needed. In addition, the sizes of the above various support members are usually larger than the sizes of the partition strip, so as to realize a better support effect. As shown in Fig. 7, a width L1 of the support member 20 is larger than a width L2 of the partition strip 2.

In one embodiment, in order to increase the stability of the partition strip, and increase the strength of the metal housing, the plurality of micro vias are further filled with insulation filler, for example, particle made of any insulation material. Since the micro vias are very small, the naked eyes of the person cannot see the insulation filler in the micro vias, and the partitioned metal housing will not be conducted by the insulation filler.

In one embodiment, when the above support member is an insulation support member, the insulation support member and the insulation filler may be integrally formed.

According to a second aspect of embodiments of the present disclosure, there is provided a method for manufacturing an electronic communication device having a metal housing, after the metal housing is manufactured, the method may further include:

providing a plurality of micro vias passing through the metal housing, and forming a partition strip of the metal housing by at least two broken marks formed by the plurality of micro vias.

For example, through micro via technology, the metal housing is in-mold decorated first, a position at which the micro vias need to be punched is connected with plastics, and then the metal housing may be partitioned into several parts by punching micro vias. For another example, a plurality of micro vias may be formed by laser on an outside surface of the metal housing.

In one embodiment, the method may further include: providing a support member on an inside surface of the metal housing on which the partition strip is formed. The detailed illustration on the support member may be referred to in the above related illustration of the electronic communication device having the metal housing, which is not elaborated herein.

In one embodiment, insulation filler is filled in the plurality of micro vias. The detailed illustration on the insulation filler may be referred to in the above related illustration of the electronic communication device having a metal housing, which is not elaborated herein.

In one embodiment, when the support member is the insulation support member, the above providing a support member on an inside surface of the metal housing on which the partition strip is formed and the filling insulation filler in the plurality of micro vias may be implemented as:
squeezing from the inside surface to the outside surface of the metal housing on which the partition strip is formed by using insulation material, so that the insulation material enters into the plurality of micro vias to form the insulation filler and the insulation material forms the insulation support member on the inside surface of the metal housing on which the partition strip is formed, the insulation support member and the insulation filler are integrally formed.

In the electronic communication device manufactured through the above method provided by the embodiments of the present disclosure, the metal housing is partitioned into several parts through at least two broken marks formed by the plurality of micro vias passing through the metal housing. Since electrical conduction is suppressed between the parts of the partitioned metal housing, it is facilitate to realize the related performance of the electronic communication device, such as a signal radiation of an antenna. Furthermore, the micro vias are very small, the broken marks formed by the micro vias are also very small, and naked eyes of a person generally cannot see these micro vias and broken marks at all, thereby, slots or trace lines cannot be seen from the overall appearance of the electronic communication device, and the overall appearance is integral and beautiful.

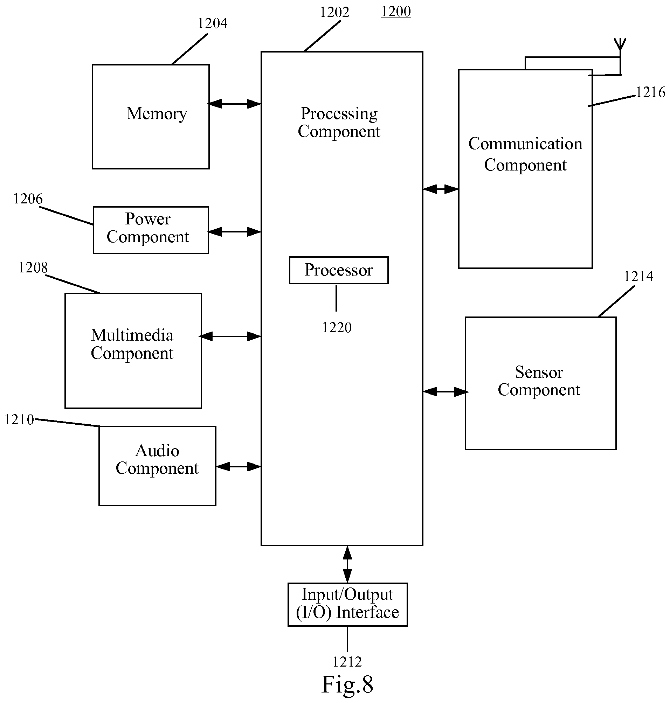

Fig. 8 is a block diagram applicable for an electronic communication device 1200 having a metal housing, according to an exemplary embodiment. The electronic communication device 1200 may be a mobile phone, a computer, a digital broadcast terminal, a messaging device, a gaming console, a tablet, a medical device, exercise equipment, a personal digital assistant, and the like.

Referring to Fig. 8, the electronic communication device 1200 may include one or more of the following components: a processing component 1202, a memory 1204, a power component 1206, a multimedia component 1208, an audio component 1210, an input/output (I/O) interface 1212, a sensor component 1214, and a communication component 1216.

The processing component 1202 typically controls overall operations of the electronic communication device 1200, such as the operations associated with display, telephone calls, data communications, camera operations, and recording operations. The processing component 1202 may include one or more processors 1220 to execute instructions to perform all or part of the steps in the above described methods. Moreover, the processing component 1202 may include one or more modules which facilitate the interaction between the processing component 1202 and other components. For instance, the processing component 1202 may include a multimedia module to facilitate the interaction between the multimedia component 1208 and the processing component 1202.

The memory 1204 is configured to store various types of data to support the operation of the electronic communication device 1200. Examples of such data include instructions for any applications or methods operated on the electronic communication device 1200, contact data, phonebook data, messages, pictures, video, etc. The memory 1204 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 1206 provides power to various components of the electronic communication device 1200. The power component 1206 may include a power management system, one or more power sources, and any other components associated with the generation, management, and distribution of power in the electronic communication device 1200.

The multimedia component 1208 includes a screen providing an output interface between the electronic communication device 1200 and the user. In some embodiments, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also sense a period of time and a pressure associated with the touch or swipe action. In some embodiments, the multimedia component 1208 includes a front camera and/or a rear camera. The front camera and the rear camera may receive an external multimedia datum while the electronic communication device 1200 is in an operation mode, such as a photographing mode or a video mode. Each of the front camera and the rear camera may be a fixed optical lens system or have focus and optical zoom capability.

The audio component 1210 is configured to output and/or input audio signals. For example, the audio component 1210 includes a microphone ("MIC") configured to receive an external audio signal when the electronic communication device 1200 is in an operation mode, such as a call mode, a recording mode, and a voice recognition mode. The received audio signal may be further stored in the memory 1204 or transmitted through the communication component 1216. In some embodiments, the audio component 1210 further includes a speaker to output audio signals.

The I/O interface 1212 provides an interface between the processing component 1202 and peripheral interface modules, such as a keyboard, a click wheel, buttons, and the like. The buttons may include, but are not limited to, a home button, a volume button, a starting button, and a locking button.

The sensor component 1214 includes one or more sensors to provide status assessments of various aspects of the electronic communication device 1200. For instance, the sensor component 1214 may detect an open/closed status of the electronic communication device 1200, relative positioning of components, e.g., the display and the keypad, of the electronic communication device 1200, a change in position of the electronic communication device 1200 or a component of the electronic communication device 1200, a presence or absence of user contact with the electronic communication device 1200, an orientation or an acceleration/deceleration of the electronic communication device 1200, and a change in temperature of the electronic communication device 1200. The sensor component 1214 may include a proximity sensor configured to detect the presence of nearby objects without any physical contact. The sensor component 1214 may further include a light sensor, such as a CMOS or CCD image sensor, for use in imaging applications. In some embodiments, the sensor component 1214 may further include an accelerometer sensor, a gyroscope sensor, a magnetic sensor, a pressure sensor, or a temperature sensor.

The communication component 1216 is configured to facilitate communication, wired or wirelessly, between the electronic communication device 1200 and other devices. The electronic communication device 1200 can access a wireless network based on a communication standard, such as WiFi, 2G, or 3G, or a combination thereof. In one exemplary embodiment, the communication component 1216 receives a broadcast signal or broadcast associated information from an external broadcast management system through a broadcast channel. In one exemplary embodiment, the communication component 1216 further includes a near field communication (NFC) module to facilitate short-range communications. For example, the NFC module may be implemented based on a radio frequency identification (RFID) technology, an infrared data association (IrDA) technology, an ultra-wideband (UWB) technology, a Bluetooth (BT) technology, and other technologies.

In exemplary embodiments, the electronic communication device 1200 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components, for performing the above described methods.

In exemplary embodiments, there is further provided a non-transitory computer-readable storage medium including instructions, such as included in the memory 1204, executable by the processor 1220 in the electronic communication device 1200, for performing the above-described methods. For example, the non-transitory computer-readable storage medium may be a ROM, a RAM, a CD-ROM, a magnetic tape, a floppy disc, an optical data storage device, and the like.

Other embodiments of the invention will be apparent to those skilled in the art from consideration of the specification and practice of the invention disclosed here. This application is intended to cover any variations, uses, or adaptations of the invention following the general principles thereof and including such departures from the present disclosure as come within known or customary practice in the art. It is intended that the specification and examples be considered as exemplary only, with a true scope and spirit of the invention being indicated by the following claims.

It will be appreciated that the present invention is not limited to the exact construction that has been described above and illustrated in the accompanying drawings, and that various modifications and changes may be made without departing from the scope thereof. It is intended that the scope of the invention should only be limited by the appended claims.

## Claims

1. An electronic communication device having a metal housing, comprising:
a partition strip, formed on the metal housing, wherein the partition strip is formed by at least two broken marks formed by a plurality of micro vias passing through the metal housing.

2. The electronic communication device according to claim 1, wherein
the plurality of micro vias comprise a plurality of micro vias formed by laser on an outside surface of the metal housing.

3. The electronic communication device according to claim 1, further comprising:
a support member, provided on an inside surface of the metal housing on which the partition strip is formed.

4. The electronic communication device according to claim 3, wherein
a size of the support member is larger than a size of the partition strip.

5. The electronic communication device according to any one of claims 1-4, wherein
the plurality of micro vias are filled with insulation filler.

6. The electronic communication device according to claim 5, wherein
the support member comprises an insulation support member; and
the insulation support member and the insulation filler are integrally formed.

7. The electronic communication device according to claim 1, wherein
a shape of the partition strip is a shape of the broken mark formed by micro vias at an outer edge among the plurality of micro vias; and
a broken mark formed by micro vias enclosed within the micro vias at the outer edge and the broken mark formed by the micro vias at the outer edge are parallel to each other.

8. The electronic communication device according to claim 1, wherein
a cavity surrounded by the metal housing is provided with an antenna; and
a position of the partition strip on the metal housing corresponds to a signal radiation position of the antenna.

9. The electronic communication device according to claim 1 or 8, wherein
the metal housing comprises one or both of a metal frame and a metal back housing; and
the partition strip is formed on one or both of the metal frame and the metal back housing.

10. The electronic communication device according to claim 9, wherein
a number of the partition strips formed on the metal frame is at least two; and
a part of the metal frame between two adjacent partition strips among the at least two partition strips is used to form a part of the antenna in the electronic communication device.

11. The electronic communication device according to claim 9, wherein
a number of the partition strips formed on the metal back housing is at least two; and
a part of the metal back housing between two adjacent partition strips among the at least two partition strips is used to form a part of the antenna in the electronic communication device.

12. The electronic communication device according to claim 11, wherein
a shape of a region partitioned, on the metal back housing, by the partition strip formed on the metal back housing couples and matches with the antenna.

13. A method for manufacturing an electronic communication device having a metal housing, comprising:
providing a plurality of micro vias passing through the metal housing, and forming a partition strip of the metal housing by at least two broken marks formed by the plurality of micro vias.

14. The method according to claim 13, wherein the providing a plurality of micro vias passing through the metal housing comprises:
forming a plurality of micro vias by laser on an outside surface of the metal housing.

15. The method according to claim 13, further comprising:
providing a support member on an inside surface of the metal housing on which the partition strip is formed.

16. The method according to claim 15, wherein
a size of the support member is larger than a size of the partition strip.

17. The method according to any one of claims 13-16, further comprising:
filling insulation filler in the plurality of micro vias.

18. The method according to claim 17, wherein
the support member comprises an insulation support member;
the providing a support member on an inside surface of the metal housing on which the partition strip is formed and the filling insulation filler in the plurality of micro vias comprise:
squeezing from the inside surface to the outside surface of the metal housing on which the partition strip is formed by using insulation material, so that the insulation material enters into the plurality of micro vias to form the insulation filler and the insulation material forms the insulation support member on the inside surface of the metal housing on which the partition strip is formed, and the insulation support member and the insulation filler are integrally formed.
